# EUROPÄISCHE PATENTSCHRIFT

(11) **EP 1 231 360 B1**
(45) Veröffentlichungstag und Bekanntmachung des Hinweises auf die Patenterteilung: **05.04.2006**
(21) Anmeldenummer: 02000496.6
(22) Anmeldetag: 09.01.2002
(51) Int. Cl.: F01L 9/04, F02D 41/06, F02D 33/02

(54) **Verfahren zum Starten einer Brennkraftmaschine mit elektromagnetischen Ventiltrieben**
Method for starting an internal combustion engine with electromagnetic valve drives
Procédé de démarrage d'un moteur à combustion interne à soupapes électromagnétiques

(30) Priorität: 10.02.2001 DE 10106156
(43) Veröffentlichungstag der Anmeldung: 14.08.2002
(73) Patentinhaber: Bayerische Motoren Werke Aktiengesellschaft, 80809 München (DE)
(72) Erfinder: Pischinger, Martin, Dr., 52072 Aachen (DE); Lutz, Steffen, 85757 Karlsfeld (DE)

(56) Entgegenhaltungen:
- EP-A- 1 054 138
- EP-A- 1 076 163
- DE-A- 10 009 320
- DE-C- 19 851 214
- US-A- 4 614 170
- PATENT ABSTRACTS OF JAPAN Bd. 1999, Nr. 01, 29. Januar 1999 (1999-01-29) & JP 10 288013 A (TOYOTA MOTOR CORP), 27. Oktober 1998 (1998-10-27)

## Beschreibung

Die Erfindung betrifft ein Verfahren zum Starten einer Brennkraftmaschine mit einem elektromagnetischen Ventiltrieb.

Bei Verbrennungsmotoren, die mit elektromagnetischen bzw. elektromechanischen Ventiltrieben ausgestattet sind, werden die Ventile nicht in herkömmlicher Weise über eine Nockenwelle betrieben, sondern durch Beaufschlagung von Elektromagnetspulen, unter deren Wirkung ein mit einem Ventil mittel- oder unmittelbar verbundener Anker hin- und herbewegt wird.

Um einen sauberen Verbrennungsstart des Verbrennungsmotors zu gewährleisten, müssen möglichst alle elektromagnetisch betätigten Ventile bereits vor dem Verbrennungsstart funktionsgerecht betrieben sein. Dazu ist es notwendig, für jeden Aktor einen Anschwingvorgang einzuleiten, bei dem die zugeordneten Anker - und damit die Ventile - aus ihrer Ruhelage ausgelenkt und in den Betriebs-Schwingungszustand überführt werden (EP 1054138) Dieser Anschwingvorgang wird nachfolgend als Start eines Aktors bezeichnet.

Die Energie zum Starten der vorhandenen Aktoren muss vor dem Start des Verbrennungsmotors aus einer Batterie oder einem anderen Energieversorger kommen. Alternativ zu einer Batterie können beispielsweise auch Brennstoffzellen zur Energieerzeugung eingesetzt werden.

In allen Fällen ist es jedoch problematisch, alle Aktoren gleichzeitig zu starten, da dann möglicherweise Belastungsspitzen auftreten können, die kein Energieversorgungssystem bereitzustellen vermag.

Aus diesem Grund wurde im Stand der Technik bereits vorgeschlagen, alle vorhandenen Aktoren einzeln und nacheinander - also ohne Überlapp - zu starten. Dies hilft, eine Überlastung von Energieversorgungssystemen zu vermeiden. Allerdings kann eine solche Vorgehensweise bei der Existenz einer Vielzahl von Aktoren (beispielsweise bei 8-Zylinder-Motoren) zu einer erheblichen Zeitverzögerung beim Motorstart führen.

Vorteilhaft im Sinne eines schnellen Motorstarts wäre es, mehrere Aktoren gleichzeitig starten zu lassen. Dies birgt jedoch wiederum das Risiko der Überlastung eines vorhandenen Energieversorgungssystems.

Aufgabe der vorliegenden Erfindung ist es, ein Verfahren zum Starten einer Brennkraftmaschine mit elektromagnetischen Ventiltrieben anzugeben, welches für jede Fahrsituation einen möglichst schnellen Motorstart realisieren lässt.

Diese Aufgabe wird durch die im Anspruch 1 genannten Merkmale gelöst.

Demgemäss wird vor dem Beginn des Verbrennungsablaufs zunächst ein Anker eines ersten Ventiltriebs mit vordefinierten ersten Parametern gestartet. Diese Parameter können fest hinterlegt oder aber auch veränderlich, z.B. in Abhängigkeit von Umgebungs- und/oder Fahrbetriebsbedingungen, gewählt werden. So kann die Temperatur eines Betriebsmittels des Fahrzeugs (z.B. Kühlwasser) oder die Umgebungstemperatur zur Ermittlung der Startbedingung verwendet werden. Auch die Art des Starts der Aktoren kann von solchen Parametern abhängig gewählt werden. Beispielsweise kann der Aktuator durch einmaliges Anziehen des Ankers gestartet werden. Alternativ kann auch ein Anschwingen in der Resonanzfrequenz des Aktors erfolgen. Das Starten durch einmaliges Anziehen benötigt zwar einen höheren Strom, ist jedoch im Vergleich zum Starten durch Anschwingen kürzer. Bei sehr niedrigen Umgebungstemperaturen bzw. Fahrzeugbetriebsmitteltemperaturen sollte der Start durch einmaliges Anziehen erfolgen, da das Schwingungsverhalten durch die geringe Viskosität des Öls sehr stark gedämpft wird. Ein Anschwingen in der Resonanzfrequenz ist damit nicht durchführbar. Beide Startverfahren belasten eine Batterie unterschiedlich.

Während des Starts des Ankers des ersten Ventilstriebs wird dann zumindest eine Größe erfasst, welche die Anschwingsituation mittelbar oder unmittelbar beschreibt. Beispielsweise kann es sich bei dieser Größe um die Batteriespannung handeln. Aus dem Spannungseinbruch ist es möglich, auf den Ladezustand und die Leistungsfähigkeit der Batterie zu schließen. Gemäß einer weiteren Ausführungsform kann als Größe auch der Ventilhub bzw. daraus abgeleitete Größen erfasst und zur Beurteilung der Anschwingsituation verwendet werden. So lässt sich auch aus der Ventilbeschleunigung unter Berücksichtigung des Masse-Feder-Schwingungssystems auf die Leistungsfähigkeit der Batterie oder die Ankerreibung schließen. Natürlich können auch weitere Größen berücksichtigt werden, die ebenfalls Aufschluss über die Anschwingsituation geben.

Anhand der ermittelten zumindest einen Größe kann eine Anzahl von Aktoren bestimmt werden, die im nächsten Schritt zu starten sind. Ergänzend kann auch die Art des Ankerstartes im nächsten Startschritt - also für die nächsten Anker - aufgrund dieser Größe festgelegt werden.

Im nächsten Startschritt wird die vorher bestimmte Anzahl der Aktoren dann gestartet, wobei wiederum zumindest eine Größe (evtl. die gleiche Größe) erfasst wird, welche wiederum die Anschwingsituation beschreibt.

So kann durch die vorliegende Erfindung der aktuelle Batteriezustand und/oder das aktuelle Reibungsverhalten der Aktoren ermittelt und bei der Bestimmung der Aktorstartvorgänge berücksichtigt werden. Die Anzahl der parallel gestarteten Aktoren wird damit in einer Größenordnung gehalten werden, dass auch bei minimalem Ladezustand der Batterie und hohem Strombedarf der Aktoren ein sicherer Start gewährleistet ist. Insgesamt kann man also einen funktionssicheren und batterieschonenden sowie schnellen Motorstart bei Verbrennungskraftmaschinen mit elektromagnetischen Ventiltrieben sicherstellen.

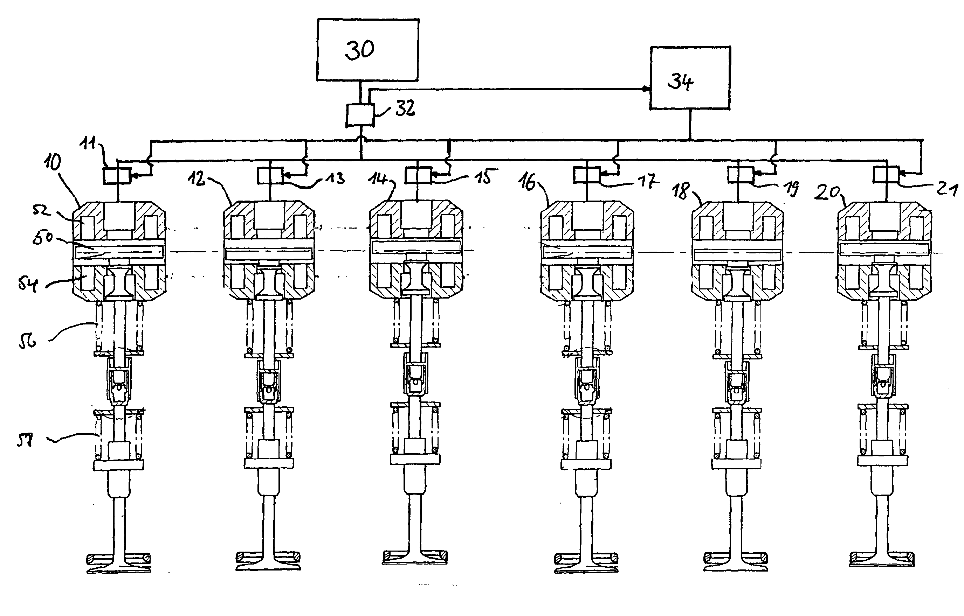

Eine Ausführungsform der vorliegenden Erfindung wird nachfolgend unter Bezugnahme auf die einzige beiliegende Zeichnung näher erläutert. Die einzige Zeichnung zeigt eine schematische Darstellung einer Anzahl von elektromagnetischen Ventiltrieben mit einer erfindungsgemäßen Ansteuerung.

Beim vorliegenden Ausführungsbeispiel sind sechs Gaswechselventile mit ihren jeweiligen elektromagnetischen Ventiltrieben 10, 12, 14, 16, 18 und 20 dargestellt. Alle Gaswechselventile und alle Ventiltriebe sind vorliegend gleich aufgebaut, so dass der prinzipielle Aufbau nur an einem Gaswechselventil erläutert werden muss.

Bei jedem Ventil wird ein mit einem Ventilschaft verbundener Anker 50 durch Beaufschlagung zweier Elektromagnetspulen 52 und 54 zwischen diesen hin- und herbewegt, und zwar jeweils gegen die Kraft einer einer jeweiligen Elektromagnetspule zugeordneten Ventilfeder 56 und 58. Diese Betriebsweise ist an sich bekannt und muß vorliegend nicht näher erläutert werden.

Bei nichtbestromten Elektromagnetspulen befindet sich der Anker 50 in einer Mittellage. Beim Betrieb eines nicht näher dargestellten Verbrennungsmotors, in dem die einzelnen Gaswechselventile bezüglich ihrer Gaswechselfunktion eingebaut sind, bewegen sich die Anker im gesamten Bereich zwischen den einzelnen Elektromagnetspulen 52 und 54 hin und her, wodurch die Öffnung bzw. Schließung des im unteren Bereich der Zeichnung skizzierten Ventiltellers betrieben wird. Vor dem Beginn des Verbrennungsablaufes müssen die jeweiligen Anker 50 aus ihrer Ruhelage verfahren und in eine festgelegte Schwingung überführt werden. Dazu ist ein Anschwingen notwendig, das nachfolgend als "Starten" bezeichnet wird.

Gemäss dem vorliegenden Ausführungsbeispiel ist jeder elektromagnetische Aktor 10, 12, 14, 16, 18 und 20 schematisch mit einer Stromversorgung in Form einer Batterie 30 verbunden. Die Batterie 30 speist in nicht konstruktiv näher dargestellter Weise die beiden Elektromagnetspulen 52 und 54 der jeweiligen Aktoren 10, 12, 14, 16, 18 und 20. Die Steuerung der Stromversorgung der einzelnen Spulen 52, 54 übernimmt eine Regelungseinrichtung 34, die nur blockschematisch dargestellte Steuerelektroniken 11, 13, 15, 17, 19 und 21 der jeweiligen Aktoren 10, 12, 14, 16, 18 und 20 kontrolliert.

Der Startvorgang beim vorliegenden Ausführungsbeispiel läuft nun folgendermaßen ab. Bevor die kontrollierte Verbrennung des nicht dargestellten Verbrennungsmotors beginnt, wird zunächst unter in einem Speicher der Steuer- und Regeleinrichtung 34 festgelegten Parametern der Aktor 10 unter Ansteuerung der zugeordneten Steuerelektronik 11 gestartet. Vorliegend findet dabei ein einmaliges Anziehen des Ankers an die Elektromagnetspule 52 statt. Sodann findet eine Überführung in den normalen Schwingungsvorgang statt. Während des Anschwingvorgangs wird über eine Messeinrichtung 32 die Spannung der Batterie 30 erfasst. Durch den Spannungseinbruch an der Batterie 30 kann auf den Ladezustand der Batterie 30 bzw. die Leistungsfähigkeit der Batterie 30 geschlossen werden. Überdies ist es möglich, auch andere Faktoren, wie das Reibungsverhalten im Aktor damit zu berücksichtigen, da mit höheren Reibungsverlusten ein stärkerer Spannungseinbruch einhergehen wird. Aufgrund der erfassten Batteriespannung wird dann in der Steuer- und Regeleinrichtung 34 vorausberechnet, wie viele Aktoren als nächstes gestartet werden können. Überdies kann auch die Art des Ankerstarts bzw. die zugeordneten Parameter beeinflusst bzw. geändert werden.

Im vorliegenden Fall wird aus dem Einbruch der Batteriespannung beim Anschwingen des Aktors 11 geschlossen, dass in der nächsten Startphase zwei Aktoren gestartet werden können.

Ist nun der erste Aktor 10 vollständig gestartet, so beginnt der gleichzeitige Start der beiden Aktoren 12 und 14 in einer von der Steuer- und Regeleinrichtung 34 festgelegten Weise. Auch während dieses Startvorgangs wird die Batteriespannung über die Messeinrichtung 32 ermittelt und wiederum der Steuer- und Regeleinrichtung 34 zur Verfügung gestellt. Diese errechnet aus dieser Eingangsgröße wiederum die Anzahl der in einem nächsten Schritt zu startenden Aktoren.

Beim vorliegenden Beispiel bestimmt die Steuer- und Regeleinrichtung 34 dann, dass alle übrigen Aktoren 16, 18 und 20 gleichzeitig gestartet werden können, was sie nach dem vollständigen Start der Aktoren 12 und 14 auch veranlasst.

Auf diese Weise können alle startbestimmenden Faktoren auf einfache Weise, nämlich unter Ermittlung des Spannungseinbruchs der Batteriespannung berücksichtigt und eine darauf abgestimmte Startstrategie aufgebaut werden. Beim oben geschilderten Startvorgang werden damit drei Gruppen von Aktoren nacheinander gestartet, nämlich zunächst der Aktor 10, dann die beiden Aktoren 12 und 14 und dann die restlichen Aktoren 16, 18 und 20. Damit lässt sich die Zeit, die bis zum tatsächlichen Start des Verbrennungsmotors abgewartet werden muss, signifikant verkürzen. Überdies wird mit der Startstrategie die Gefahr einer Überlastung der Spannungs- und Stromversorgung vermieden.

## Patentansprüche

1. Verfahren zum Starten einer Brennkraftmaschine mit zumindest zwei elektromagnetischen Ventiltrieben, bei denen jeweils ein Anker durch elektrische Beaufschlagung von Elektromagnet-Spulen hin- und herbewegt wird,
**dadurch gekennzeichnet,**
**dass** vor dem Start des Verbrennungsablaufs zunächst ein Anker eines ersten Ventiltriebes mit vordefinierten ersten Parametern gestartet wird,
**dass** während des Starts des Ankers des ersten Ventiltriebs zumindest eine Größe erfasst wird, die einen Aufschluss über die Anschwingsituation angibt, dass aus der zumindest einen Größe eine Anzahl von Aktoren für den nächsten Schritt bestimmt wird,
**dass** in einem nächsten Schritt die vorher bestimmte Anzahl von Aktoren gestartet wird, wobei wiederum zumindest eine Größe erfasst wird, welche die Anschwingsituation beschreibt, und
**dass** die vorhergehenden Schritte sooft durchgeführt werden, bis alle Aktoren gestartet sind.

2. Verfahren nach Anspruch 1,
**dadurch gekennzeichnet,**
**dass** während des Starts des Ankers des ersten Ventiltriebs aus der zumindest einen Größe eine Startart für die bestimmte Anzahl von Aktoren bestimmt wird, und im nächsten Schritt die zuvor bestimmte Anzahl von Aktoren gemäß der zuvor bestimmten Startart gestartet wird.

3. Verfahren nach Anspruch 1 oder 2,
**dadurch gekennzeichnet,**
**dass** die ersten Parameter von Fahrzeug- oder Umgebungsparametern abhängig gemacht werden.

4. Verfahren nach einem der vorhergehenden Ansprüche,
**dadurch gekennzeichnet,**
**dass** als Umgebungsparameter die Temperatur verwendet wird.

5. Verfahren nach einem der vorhergehenden Ansprüche,
**dadurch gekennzeichnet**,
das als Fahrzeugparameter eine oder mehrere Temperaturen eines Betriebsmittels verwendet wird.

6. Verfahren nach einem der vorhergehenden Ansprüche,
**dadurch gekennzeichnet,**
**dass** als die zumindest eine Größe die Batteriespannung erfasst wird.

7. Verfahren nach einem der vorhergehenden Ansprüche,
**dadurch gekennzeichnet,**
**dass** als die zumindest eine Größe der Hub des Ankers erfasst wird.

8. Verfahren nach einem der vorhergehenden Ansprüche,
**dadurch gekennzeichnet,**
**dass** das Starten der Aktoren durch einmaliges Anziehen des Ankers an eine Elektromagnetspule erfolgt.

9. Verfahren nach einem der vorhergehenden Ansprüche 1 bis 6,
**dadurch gekennzeichnet,**
**dass** das Starten durch Anschwingen in der Resonanzfrequenz der Aktoren erfolgt.

10. Verfahren nach einem der vorhergehenden Ansprüche,
**dadurch gekennzeichnet,**
**dass** die Art des Starts von Parametern abhängig gemacht wird.

## Claims

1. A method for starting an internal-combustion engine with at least two electromagnetic valve drives, in which, in each case, an armature is moved back and forth by means of the electrical loading of electromagnetic coils, **characterised in that** an armature of a first valve drive is firstly started with predefined first parameters prior to the start of the combustion sequence, **in that** during the starting of the armature of the first valve drive, at least one variable is detected which provides information about the oscillation starting situation, **in that** a number of actuators for the next step is determined from the at least one variable, **in that** the previously determined number of actuators is started in a next step, at least one variable in turn being detected, which describes the oscillation starting situation, and **in that** the previous steps are carried out until all the actuators have been started.

2. A method according to claim 1, **characterised in that** during the start of the armature of the first valve drive, a starting manner for the specific number of actuators is determined from the at least one variable, and the previously determined number of actuators is started in the next step according to the previously determined starting manner.

3. A method according to claim 1 or 2, **characterised in that** the first parameters are made dependent on vehicle or environmental parameters.

4. A method according to any one of the preceding claims, **characterised in that** the temperature is used as an environmental parameter.

5. A method according to any one of the preceding claims, **characterised in that** one or more temperatures of an operating means is/are used as the vehicle parameter.

6. A method according to any one of the preceding claims, **characterised in that** the battery voltage is detected as the at least one variable.

7. A method according to any one of the preceding claims, **characterised in that** the lift of the armature is detected as the at least one variable.

8. A method according to any one of the preceding claims, **characterised in that** the actuators are started by a single attraction of the armature to an electromagnetic coil.

9. A method according to any one of the preceding claims 1 to 6, **characterised in that** starting takes place by starting oscillation in the resonance frequency of the actuators.

10. A method according to any one of the preceding claims, **characterised in that** the manner of starting is made dependent on parameters.

## Revendications

1. Procédé de démarrage d'un moteur à combustion interne comportant au moins deux entraînements de soupape électromagnétique, dans chacun desquels un induit est déplacé en avant et en arrière par alimentation électrique de bobines électromagnétiques,
**caractérisé en ce qu'**
avant le démarrage du processus de combustion, un induit d'un premier entraînement de soupape est d'abord démarré avec des premiers paramètres prédéfinis,
pendant le démarrage de l'induit du premier entraînement de soupape au moins une grandeur est détectée qui donne une information concernant la situation d'amorçage d'oscillation,
à partir de l'au moins une grandeur, un nombre d'actionneurs est déterminé pour l'étape suivante,
dans une étape suivante, le nombre d'actionneurs préalablement déterminé est démarré en détectant à nouveau au moins une grandeur qui décrit la situation d'amorçage d'oscillation, et
les étapes précédentes sont exécutées jusqu'à ce que tous les actionneurs soient démarrés.

2. Procédé selon la revendication 1,
**caractérisé en ce que**
pendant le démarrage de l'induit du premier entraînement de soupape, un mode de démarrage est déterminé à partir de l'au moins une grandeur pour le nombre déterminé d'actionneurs, et dans l'étape suivante le nombre d'actionneurs préalablement déterminé est démarré suivant le mode de démarrage préalablement déterminé.

3. Procédé selon la revendication 1 ou 2,
**caractérisé en ce que**
les premiers paramètres sont fonction de paramètres de véhicule ou d'environnement.

4. Procédé selon l'une quelconque des revendications précédentes,
**caractérisé en ce que**
la température est utilisée comme paramètre d'environnement.

5. Procédé selon l'une quelconque des revendications précédentes,
**caractérisé en ce qu'**
une ou plusieurs températures d'un agent de fonctionnement sont utilisées comme paramètre de véhicule.

6. Procédé selon l'une quelconque des revendications précédentes,
**caractérisé en ce que**
la tension de batterie est détectée comme l'au moins une grandeur.

7. Procédé selon l'une quelconque des revendications précédentes,
**caractérisé en ce que**
la course de l'induit est détectée comme l'au moins une grandeur.

8. Procédé selon l'une quelconque des revendications précédentes,
**caractérisé en ce que**
le démarrage des actionneurs s'effectue par une attraction unique de l'induit contre une bobine électromagnétique.

9. Procédé selon l'une quelconque des revendications précédentes 1 à 6,
**caractérisé en ce que**
le démarrage s'effectue par amorçage d'oscillation à la fréquence de résonance des actionneurs.

10. Procédé selon l'une quelconque des revendications précédentes,
**caractérisé en ce que**
le mode du démarrage est fonction de paramètres.
